# EUROPEAN PATENT SPECIFICATION

(11) **EP 0 598 563 B1**
(45) Date of publication and mention of the grant of the patent: **27.12.1996**
(21) Application number: 93309047.4
(22) Date of filing: 11.11.1993
(51) Int. Cl.: H02M 7/5387, H05K 7/06, H01L 23/64

(54) **Semiconductor conversion device**
Halbleiter-Umwandlungsvorrichtung
Dispositif de conversion à semi-conducteur

(30) Priority: 18.11.1992 JP 307397/92
(43) Date of publication of application: 25.05.1994
(60) Divisional application: 96100276.3
(73) Proprietor: FUJI ELECTRIC CO. LTD., Kawasaki 210 (JP)
(72) Inventor: Terasawa, Noriho, Matsumoto City, Nagano (JP)
(74) Representative: Topley, Paul

(56) References cited:
- EP-A- 0 166 968
- DE-A- 4 102 574
- US-A- 4 514 749
- US-A- 4 831 497
- US-A- 5 057 970
- US-A- 5 077 595
- PATENT ABSTRACTS OF JAPAN vol. 14, no. 239 (E-930) (4182) 21 May 1990 & JP-A-02 065 238
- PATENT ABSTRACTS OF JAPAN vol. 8, no. 63 (E-233) 24 March 1984 & JP-A-58 213 456

## Description

The present invention relates to a semiconductor conversion device comprising semiconductor switching elements in a main circuit configured as a bridge circuit.

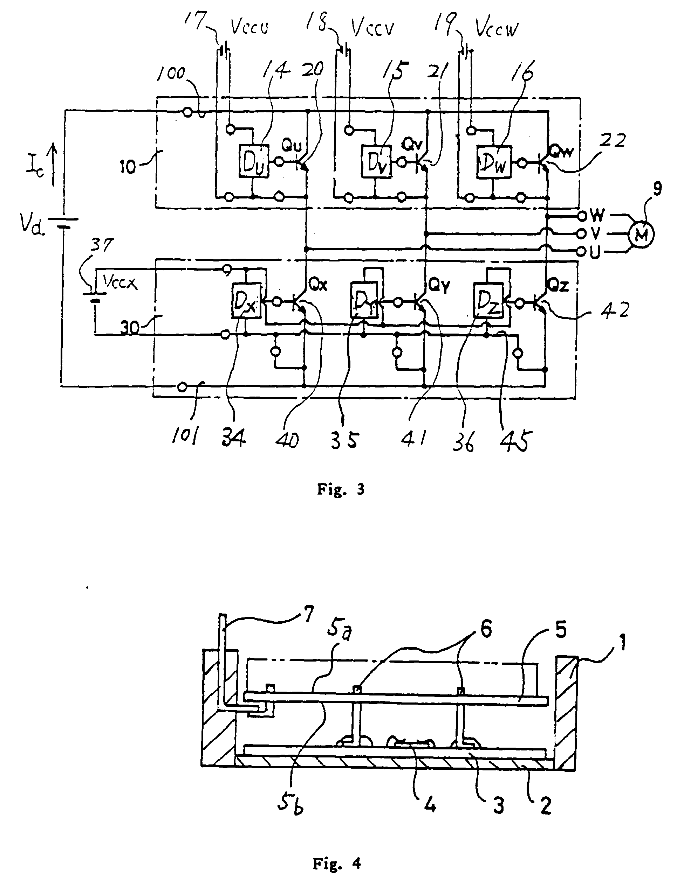

Semiconductor conversion devices having semiconductor switching elements in a main circuit configured as a bridge circuit and converting direct currents to alternating currents and vice versa in order to supply converted currents to loads have already been used as inverters or the like for electric power and many other applications. Such semiconductor conversion devices generally include three-phase inverter circuits that convert direct currents to three-phase alternating currents with a variable frequency. Figure 3 of the accompanying drawings shows an example of such a three-phase inverter circuit. This three-phase inverter is a semiconductor conversion device which has a three-phase bridge circuit configuration, and which supplies three-phase alternating currents to an electric motor 9 using a main DC power supply Vd. The three-phase inverter consists of an upper-arm circuit 10 which controls the high electrical potential side of the three-phase alternating voltage and a lower-arm circuit 30 which controls the low electrical potential side of the three-phase alternating voltage.

The upper-arm circuit 10 comprises a main circuit and a drive circuit. The main circuit in the upper arm circuit 10 is composed of bipolar transistors 20 to 22, which are known as semiconductor switching elements and are provided for the U, V, and W arms, respectively. The drive circuit in the upper arm circuit 10 is composed of individual drive circuits 14 to 16 (referenced D_{U} D_{V} and D_{W} in the Figure) which individually deliver drive signals that cause the respective transistors 20 to 22 to perform switching operations. Supplementary DC power supplies 17 to 19 are separately insulated from the outside, and control signals (not shown) are input to the respective individual drive circuits 14 to 16.

The lower-arm circuit 30 has almost the same configuration as the upper-arm circuit 10. The main circuit in the lower-arm circuit 30 is composed of bipolar transistors 40 to 42, which are known as semiconductor switching elements and are provided for the X, Y, and Z arms, respectively. The drive circuit in the lower-arm circuit 30 is composed of individual drive circuits 34 to 36 (referenced D_{X} D_{Y} and D_{Z} in the Figure) which individually deliver drive signals that cause the respective transistors 40 to 42 to perform switching operations. A common outside supplementary DC power supply 37 and control signals (not shown) are input to the individual drive circuits 34 to 36.

The three-phase inverter comprising the circuit configuration shown in Figure 3 is supplied with main DC electric currents Ic from the main DC power supply (Vd) through a positive-electrode main circuit line 100 and a negative-electrode main circuit line 101. The switching operations of the transistors 20 to 22 and 40 to 42 allow the DC-side main electric currents to start from the positive electrode of the main DC power supply (Vd) and flow through the main circuit line 100, one of the transistors 20 to 22, the electric motor 9, one of the transistors 40 to 42, and the main circuit line 101, in that order, and finally to reach the negative electrode of the main DC power supply (Vd) and supply three-phase alternating voltage to the electric motor 9.

Two circuit substrates, shown in Figure 4, are often used to configure a three-phase inverter with the above circuit configuration. That is, the main circuit composed of transistors 20 to 22 and 40 to 42 is configured on a main circuit substrate 3, onto which a semiconductor chip 4 having the required functions is mounted. In addition, the individual drive circuits 14 to 16 and 34 to 36 are configured on a drive circuit substrate 5, onto which these individual drive circuits are integrally mounted. Both the main circuit substrate 3 and drive circuit substrate 5 are housed within a container consisting of a case 1 and a base 2, which has good thermal conductivity. The main circuit substrate 3 and drive circuit substrate 5 are connected to each other via an internal connection lead 6. In addition, the drive circuit substrate 5 is supplied with external control signals and supplementary power supplies 17 to 19 and 37 via external connections , shown as leads 7 in the Figure.

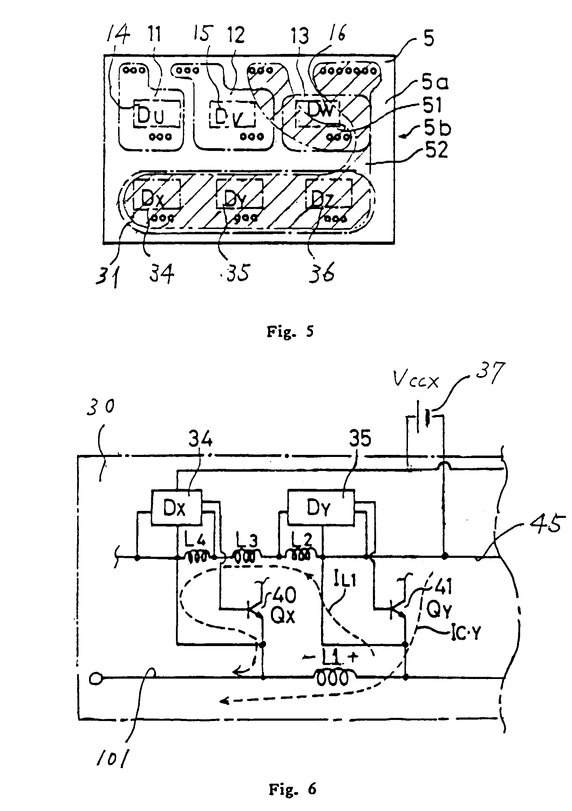

In conventional three-phase inverters, the drive circuit substrate 5 is configured as shown in Figure 5. That is, a double-sided printed circuit-type substrate is used as a drive circuit substrate 5 and the individual drive circuits 14 to 16 and 34 to 36 are mounted together on the upper surface 5a of the drive circuit substrate 5. In the individual drive circuits 14 to 16, various ground electrical potentials are connected to the various transistor emitters 20 to 22 provided in the upper-arm circuit 10. Thus, the conductor areas 11 to 13, on which the individual drive circuits are mounted, individually consist of a foil-like conductor on the upper surface 5a of the double-side printed circuit-type substrate. In this case, the conductor areas 11, 12 for the individual drive circuits 14, 15 are integrally formed with a terminal part connected to the connection leads 6, 7. However, the conductor area 13 for the individual drive circuit 16 has a separately formed part, a conductor area 51, which extends to a terminal part connected to the connection leads 6, 7. The conductor area 51 consists of a foil-like conductor on the under-surface 5b of the double-sided printed circuit-type substrate.

In addition, in the individual drive circuits 34 to 36, respective ground electrical potentials are connected to a line 45 (see Figure 3) to which the respective emitters of the transistors 40 to 42 provided in the upper-arm circuit 30 are connected. The line 45 is a common ground electrical potential line used to provide a ground electrical potential which is equal to a common reference electrical potential for the negative electrode side. Thus, individual drive circuits 34 to 36 are mounted on a common conductor area 31. In addition, the conductor area 31 consists of a foil-like conductor on the upper surface 5a of the double-sided printed circuit-type substrate. In this case, the conductor area 31 has a separately formed part, a conductor area 52, which extends to a terminal part connected to connection leads 6, 7. The conductor area 52 consists of a foil-like conductor on the under-surface 5b of the double-sided printed circuit-type substrate.

That is, the conventional drive circuit substrate 5 shown in Figure 5 has conductor areas on both the upper surface 5a and the under-surface 5b. However, the double-sided printed circuit-type substrate enables the required electrical insulation to be sufficiently ensured between the individual drive circuits 14 to 16 and between the individual drive circuits 14 to 16 and the conductor area 31 composed of individual drive circuits 34 to 36.

In the three-phase inverter with the circuit configuration shown in Figure 3, the upper transistors 20 to 22 and lower transistors 40 to 42 alternately and periodically perform switching operations in response to control signals in order to convert the main DC power supply (Vd) to three-phase alternating currents. In this case, the respective upper-arm transistors 20 to 22 perform switching operations at time intervals corresponding to an electric angle of 120° to keep three-phase alternating currents balanced. Furthermore, the group of the upper-arm transistors 20 to 22 and the group of lower-arm transistors 40 to 42 must alternatively perform switching operations at time intervals corresponding to an electric angle of 180° so that opposing transistors, for example, transistors 20 and 40 will not be simultaneously turned on.

One of the most important matters to consider when configuring a semiconductor conversion device is the prevention of semiconductor switching element malfunctions. A malfunctioning semiconductor switching element will cause an arm to short, allowing excess electric currents to flow in the circuit. As a result, serious accidents such as the destruction of the semiconductor switching element or of equipment to be driven such as the electric motor may occur.

Recent advances in semiconductor technology have substantially reduced the malfunction of semiconductor switching elements, and have improved the reliability of semiconductor conversion devices. However, such malfunctions may also be caused by factors other than the semiconductor switching elements. Among them is the configuration of the drive circuit substrate. In a three-phase inverter, the electrical potentials of the emitters of the transistors 20 to 22 vary at different times in response to the abovementioned switching operations of the transistors 20 to 22 and 40 to 42. Thus, in the drive circuit substrate provided in the three-phase inverter, the electrical potentials of the respective conductor areas connected to the transistors 20 to 22 are constantly changing.

For the configuration of the drive circuit substrate 5 provided in the prior art three-phase inverter described above, the conductor area 13 on which the individual drive circuit 16 is mounted and the conductor area 51 which is electrically connected thereto should be noted. That is, the conductor areas 13 and 52 or the conductor areas 51 and 12 have parts extending over the same areas of he substrate, but on different surfaces of the substrate with the insulated substrate of the double-sided printed circuit-type substrate in between. These opposing parts provides a relatively large parasitic capacitance because they have a configuration similar to that of a condensor. High-frequency currents easily pass through such a large parasitic capacitance. Thus, if the electrical potential of the emitter of the transistor 22 changes rapidly, high frequency currents may flow from conductor areas 13 and 51 to conductor areas 31 and 12, respectively, via the parasitic capacitance. High-frequency currents become a source of noise and may cause the transistors 21 and 40 to 42, which are driven by the individual drive circuits 15 and 34 to 36 mounted on the conductor areas 12, 31, to malfunction.

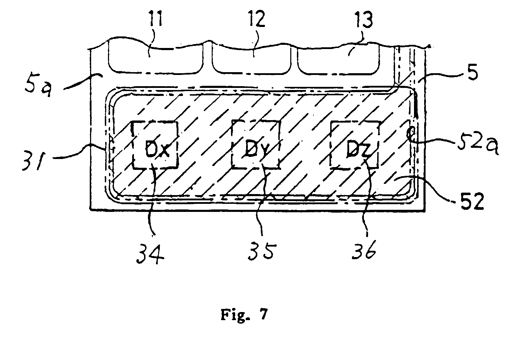

In addition, the current path in conductor area 31 is longer than that of conductor areas 11 to 13 because it has individual drive circuits 34 to 36 integrally mounted thereon. Furthermore, the current path of conductor area 52 is longer than that of the conductor area 31 because it must cover the whole range of the conductor area 31 and extend to the terminal part connected to the connection leads 6, 7. The conductor area 52 has a conductor area 52a (see Figure 7) for the common ground electrical potential line 45 formed therein. The conductor area 52a is formed in the peripheral part of the conductor area 52 surrounding the area of the conductor area 52, as shown in Figure 7. The ground electrical potential line 45 provides a common reference electrical potential for the individual drive circuits 34 to 36, and is electrically connected to the emitters of the transistors 40 to 42 and the negative electrode side of the supplementary power supply 37. Therefore, the ground electrical potential line 45 is electrically connected to the emitters of the respective transistors 40 to 42 and the main circuit line 101.

Thus, part of the main DC electric currents (Ic) branches off from the main circuit line 101 and flows to the ground electrical potential line 45. In particular, if the main DC electric currents (Ic) contain high frequency components, the inductance of the main circuit line 101 will cause more high frequency components to branch off to the ground electrical potential line 45. Figure 6 shows the important part of the ground electrical potential line 45 with the surrounding circuits in detail. As shown in this Figure, when the transistor 41 is switched on, DC-side main electric currents Ic_{Y} advancing to the negative electrode side of the main DC power supply (Vd) start to flow through the main circuit line 10 to which the emitter of the transistor 41 is connected. Immediately after the transistor 41 is switched on, the values of the main DC currents (Ic_{Y}) increase rapidly, indicating that the currents contain a large number of high-frequency components. In addition, there is always a parasitic inductance L1, either intentionally or unintentionally, on the main circuit line 101 between the part to which the emitter of the transistor 41 of the main circuit line 101 is connected and the part to which the emitter of the transistor 40 is connected. The existence of parasitic inductance (L1) enables a diverted flow I_{L1} to flow to the ground electrical potential line 45 as described below. That is, the diverted flow (I_{L1}) passes across the ground electrical potential line 45 when it starts from the main circuit line 101, passes through a junction with the emitter of the transistor 41, the ground electrical potential line 45, and a junction with the emitter of the transistor 40 in that order, finally returning to the main circuit line 101. The diverted flow (I_{L1}) generates a high-frequency voltage at parasitic inductances L2, L3, L4 of the ground electrical potential line 45. Thus, circuit elements having a ground electrical potential and connected between the inductances will have differing ground electrical potentials (the circuit elements are not shown but form the individual drive circuits 34, 35). These differing ground electrical potentials may prevent the original functions of the ground electrical potential, resulting in a malfunction of the circuit elements. In this case, such an unwelcome malfunction may occur in the transistors 40, 41 because the individual drive circuits 34, 35 deliver incorrect drive signals. This also applies to the individual drive circuit 36 for the transistor 42.

In view of the above problems, it is the objective of this invention to review conductor areas on the drive circuit substrates used for semiconductor conversion devices such as inverters and to provide a semiconductor conversion device that avoids the disadvantages of the prior art in that it rarely malfunctions.

According to the present invention, the above objective is achieved by providing a semiconductor conversion device having a bridge circuit configuration and consisting of a main circuit comprising a semiconductor switching element for at least one upper arm and one lower arm, and a drive circuit with individual drive circuits, which are mounted on the conductor areas of a foil-like conductor on a printed-circuit-type substrate and are provided in correspondence to the respective semiconductor switching elements, to cause the semiconductor switching elements to perform switching operations, said drive circuit having thereon the same printed-circuit-type substrate as the individual drive circuits which drive the semiconductor switching elements provided for the upper arms, and the individual drive circuits which drive the semiconductor switching elements provided for the lower arms, wherein the conductor area on which the individual drive circuits which drive the semiconductor switching elements provided for the upper arms are formed, and the conductor area on which the individual drive circuits which drive the semiconductor switching elements provided for the lower arms are formed, are configured so that they are not positioned in opposition to each other with the insulated material layer of the printed circuit-type substrate between them.

Preferably, the bridge circuit is a three-phase bridge circuit.

According to the invention, as described above, the conductor area having thereon individual drive circuits to drive the semiconductor switching elements provided for the upper arms, and the conductor area having thereon individual drive circuits to drive the semiconductor switching elements provided for the lower arms are formed so that they are not positioned in opposition to each other with the insulated material layer of the printed-circuit-type substrate in between.

Therefore, the value of the parasitic capacitance formed between the conductor areas is very small. As a result, the value of high-frequency noise currents flowing across the parasitic capacitance between conductor areas to a different conductor area is very small. This prevents the drive circuit from malfunctioning due to high-frequency noise currents.

An embodiment of the invention will now be describe in detail with reference to the accompanying drawings, in which:
Figure 1 is a schematic drawing illustrating the configuration of the drive-circuit substrate of a three-phase inverter according to this invention;
Figure 2 is an explanatory drawing illustrating the configuration of a ground electrical potential line with peripheral circuits in the important part of the three-phase inverter according to this invention;
Figure 3 is a circuit diagram illustrating the circuit configuration of the three-phase inverter;
Figure 4 is a sectional view illustrating the configuration of the three-phase inverter;
Figure 5 is a schematic drawing illustrating the configuration of the drive circuit substrate of a prior-art, three-phase inverter;
Figure 6 is a schematic drawing illustrating the configuration of a ground electrical potential line with peripheral circuits in the important part of a prior-art, three-phase inverter; and
Figure 7 is a schematic drawing illustrating the arrangement of the important part of the conductor area of the ground electrical potential line provided on the drive-circuit substrate of a prior-art, three-phase inverter.

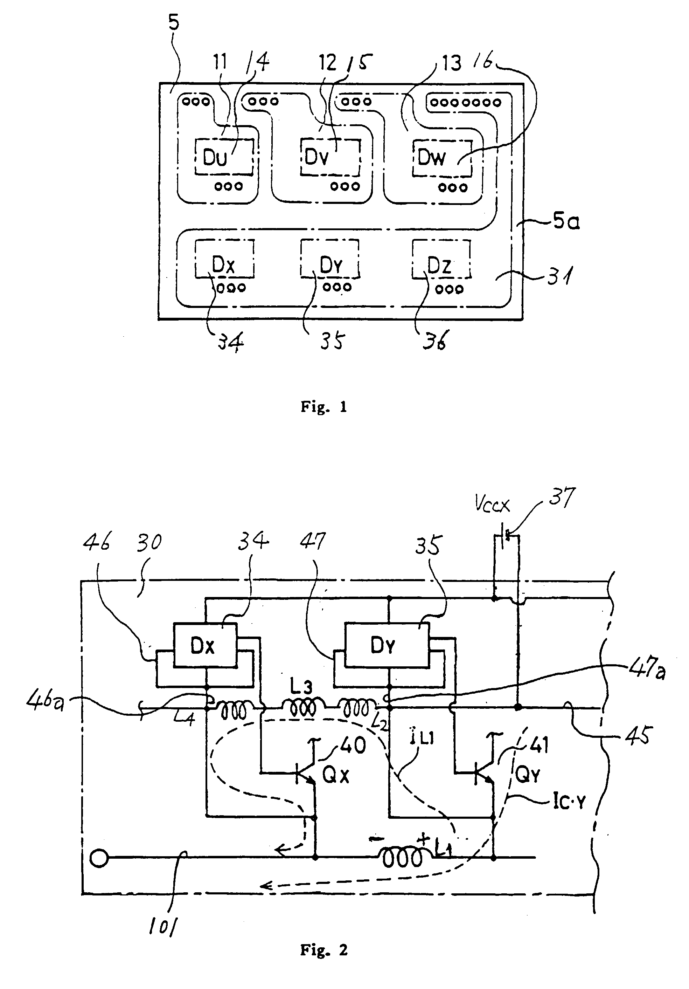

An embodiment according to this invention is explained below with reference to Figures 1 and 2 of the drawings.

Figure 1 shows the configuration of the drive circuit substrate of a three-phase inverter according to this invention. The three-phase inverter according to this invention has the same circuit configuration as the prior art described above in Figure 3. Therefore, no further description of the operation of the circuit is warranted. The three-phase inverter according to this invention consists of a main circuit substrate 5 having a configuration similar to that of the prior art described above in Figure 4, and a drive circuit substrate according to this invention on which individual drive circuits 14 to 16 and 34 to 36 are integrally mounted.

For the drive circuit substrate 5 according to this invention, which is shown in Figure 1, independent conductor areas 11 to 13 for the individual drive circuits 14 to 16 are integrally formed on the upper surface 5a of the substrate together with a terminal part connected to connection leads 6, 7. This configuration eliminates the conductor area 51, which is formed conventionally on the underside of the substrate. In addition, a common conductor area for the individual drive circuits 34 to 36 is integrally formed on the upper surface 5a of the substrate 5 together with the part of the conductor area referenced 52 in the prior art embodiment shown in Figure 5. Thus, a terminal part connected to the connection leads 6, 7 and the conductor area 52a for the ground electrical potential line 45 are also formed on the upper surface 5a of the substrate 5. Therefore, these conductor areas 11 to 13 and 31 have no overlapping parts that are opposed to each other with the insulating layer of the double-sided printed circuit-type substrate in between.

Thus, the absence of overlapping conductor areas opposed to each other makes the value of any parasitic capacitance formed between the conductor areas 11 to 13 and area 31 very small. As a result, the value of high-frequency noise currents flowing across such parasitic capacitances from one conductor area to a different conductor area is very small. This substantially reduces the possibility that the drive circuits 15 and 34 to 36 will malfunction due to high frequency noise currents, or that the transistors 21 and 40 to 42 will malfunction, which in turn allows a very reliable three-phase inverter to be made.

With reference to Figure 1, this invention was described in conjunction with the drive circuit substrate 5, which was configured using a double-sided printed circuit-type substrate, although it is not limited to such a configuration. That is, whether a single-sided or a multi-layered printed circuit-type substrate is used as a printed circuit-type substrate in a three-phase inverter with individual drive circuits driving the respective transistors provided in the main circuit with a three-bridge circuit configuration, a three-phase inverter which rarely malfunctions can of course be implemented as long as the conductor areas, on which the individual drive circuits are mounted, are disposed so that none of their parts overlap.

In addition, with reference to Figure 1, this invention was described in conjunction with a three-phase inverter, in which conventional bipolar NPN transistors are used as semiconductor switching elements, although it need not be limited to such an inverter. Similar effects can be obtained by using bipolar PNP transistors, MOSFETs, IGBTs, voltage-driven transistors or thyristors as the semiconductor switching elements.

Moreover, this invention has been described in conjunction with the conductor area 52a for the ground electrical potential line 45 formed on the periphery of the conductor area 52 so that it surrounds the area of the conductor area 52, although it need not be limited to such a configuration. If a double-sided or multilayered printed circuit-type substrate is used, the conductor area 52a may be separated from the conductor area 52, and may be formed on a different layer from the conductor on which the conductor area 52 is formed. In this case, it is preferable for the conductor area 52a to have the same shape as the conductor area 52 (except for the terminal part) and to be formed in overlapping relation to the conductor area 52. This configuration increases the sectional area of the conductor allowing the values of the parasitic inductance and resistance, which may cause variable ground electrical potentials, to be reduced.

In addition, Figure 2 is an explanatory drawing illustrating the configuration of a ground electrical potential line in the important part of a three-phase inverter. As shown in Figure 2, the three-phase inverter consists of individual ground electrical potential lines 46, 47, which individually provide ground electrical potentials that are negative-electrode-side reference electrical potentials, for the individual drive circuits delivering drive signals to the lower-arm transistors 40, 41. In addition, the drive circuit substrate 5 provided in the three-phase inverter according to this invention has graphic or wiring patterns corresponding to the individual drive circuits 46, 47 formed thereon. These individual ground electrical potential lines 46, 47 are each connected at a single point on the connection lines 46a, 47a, respectively, to the ground electrical potential line 45. The individual drive circuit 36 delivering drive signals to the lower-arm transistor 42 also has an individual ground electrical potential line formed thereon, and this individual ground electrical potential line is connected at a single point to the ground electrical potential line 45 as in the individual drive circuits 34, 35, although this is not shown in Figure 2.

Thus, in the drive circuit according to this invention wherein dedicated individual ground electrical potential lines are provided for individual drive circuits 34 to 36, when a diverted flow (only a diverted flow I_{L1} is shown in Figure 2) of the main DC currents (Ic) supplied from the main DC power supply (Vd) to the three-phase inverter main circuit flow across the ground electrical potential line 45, the ground electrical potentials of the individual ground electrical potential lines 46 to 48 become equal to the electrical potential of the point of the common ground electrical potential line 45 to which the connection lines 46a, 47a, etc. are connected. The electrical potential may vary among the individual ground electrical potential lines 46 to 48, but it is uniform within the same individual ground electrical potential line 46, 47, or 48. Thus, even if the flow across the parasitic inductances (L2, L3, L4) of the ground electrical potential line 45 is diverted, and the ground electrical potential varies among the individual drive circuits, it does not vary within each individual drive circuit 46, 47, 48. This prevents the individual drive circuits 46 to 48 from malfunctioning due to a non-uniform ground electrical potential within each individual drive circuit.

This invention has so far been described in conjunction with a case in which bipolar NPN transistors are used as semiconductor switching elements. However, if a three-phase inverter uses PNP transistors for at least the upper arm circuit part, the electrical potentials of the emitters of the transistors provided in the upper-arm circuit part will be common. Therefore, the malfunction of the individual drive circuits can be reduced by providing a dedicated individual reference electrical potential line which sets an emitter electrical potential for each individual drive circuit, as described above.

Furthermore, this invention has been described so far in conjunction with a case in which a semiconductor conversion device is an inverter; however, it need not be limited to such a device. That is, converters which convert alternating currents to direct currents can also be used as long as they are semiconductor conversion devices that include semiconductor switching elements in a main circuit with a bridge circuit configuration.

As described above, in the semiconductor conversion device according to this invention, if conductor areas that have individual drive circuits which drive semiconductor switching elements are not formed in opposition to each other with the insulated layer of the printed circuit-type substrate in between, the value of the parasitic capacitance formed between the conductor areas will be very small. This, in turn, makes the value of the high-frequency noise currents flowing across the parasitic capacitance between conductor areas to a different conductor area very small, which prevents individual drive circuits from malfunctioning because of high-frequency noise currents.

Such a semiconductor conversion device can be applied to, for example, an inverter supplying a variable frequency alternating voltage to an electric motor to control it, while the decreased possibility of a malfunction of individual drive circuits serves to improve the reliability of the device and eliminate the likelihood of serious accidents such as arm short circuits.

## Claims

1. A semiconductor conversion device having a bridge circuit configuration and consisting of a main circuit comprising a semiconductor switching element (20 to 22, 40 to 42) for at least one upper arm (10) and one lower arm (30), and a drive circuit with individual drive circuits (14 to 16, 34 to 36), which are mounted on the conductor areas of a foil-like conductor on a printed-circuit-type substrate (5) and are provided in correspondence to the respective semiconductor switching elements (20 to 22, 40 to 42), to cause the semiconductor switching elements (20 to 22, 40 to 42) to perform switching operations, said drive circuit having thereon the same printed-circuit-type substrate as the individual drive circuits which drive the semiconductor switching elements (20 to 22) provided for the upper arms (10), and the individual drive circuits which drive the semiconductor switching elements (40 to 42) provided for the lower arms (30), characterised in that the conductor areas (11 to 13) in which the individual drive circuits (14 to 16) which drive the semiconductor switching elements (20 to 22) provided for the upper arms (10) are formed, and the conductor area on which the individual drive circuits (34 to 36) which drive the semiconductor switching elements (40 to 42) provided for the lower arms (30) are formed, are configured so that they are not positioned in opposition to each other with the insulated material layer of the printed circuit-type substrate (5) between them.

2. A semiconductor conversion device according to claim 1, characterised in that the bridge circuit is a three-phase bridge circuit.

## Patentansprüche

1. Halbleiter-Umwandlungsvorrichtung mit einer Brükken-Schaltungsanordnung und die aus einem Hauptstromkreis mit Halbleiter-Schaltungselementen (20 bis 22, 40 bis 42) für zumindest einen oberen Zweig (10) und einen unteren Zweig (30) besteht, und einer Treiberschaltung mit einzelnen Treiberschaltungen (14 bis 16, 34 bis 36), welche auf den Leiterbereichen aus einem folienartigen Leiter auf einem Substrat der Art einer gedruckten Schaltung (5) angebracht sind und in Zuordnung zu den jeweiligen Halbleiter-Schaltungselementen (20 bis 22, 40 bis 42) bereitgestellt werden, um die Halbleiter-Schaltungselemente (20 bis 22, 40 bis 42) Schaltoperationen ausführen zu lassen, die Treiberschaltung darauf das gleiche Substrat der Art einer gedruckten Schaltung aufweist, wie die einzelnen Treiberschaltungen, die die Halbleiter-Schaltungselemente (20 bis 22) treiben, die für die oberen Zweige (10) bereitgestellt sind, und die einzelnen Treiberschaltungen die die Halbleiter-Schaltungselemente (40 bis 42) treiben, die für die unteren Zweige (30) bereitgestellt sind,
dadurch **gekennzeichnet**,
daß die Leiterbereiche (11 bis 13), in denen die einzelnen Treiberschaltungen (14 bis 16) ausgebildet sind, die die Halbleiter-Schaltungselemente (20 bis 22) treiben, die für die oberen Zweige (10) bereitgestellt sind, und der Leiterbereich auf dem die einzelnen Treiberschaltungen (34 bis 36) ausgebildet sind, die die Halbleiter-Schaltungselemente (40 bis 42) treiben, die für die unteren Zweige (30) bereitgestellt sind, so angeordnet sind, daß sie nicht in Gegenüberlage zueinander mit der Schicht aus isoliertem Materialschicht des Substrats der Art einer gedruckten Schaltung (5) zwischen ihnen angeordnet sind.

2. Halbleiter-Umwandlungsvorrichtung nach Anspruch 1,
dadurch **gekennzeichnet**,
daß die Brückenschaltung eine Dreiphasen-Brückenschaltung ist.

## Revendications

1. Dispositif de conversion à semi-conducteurs, ayant la configuration d'un circuit en pont et constitué d'un circuit principal comportant un élément de commutation à semi-conducteurs (20 à 22, 40 à 42) destiné à au moins une branche supérieure (10) et à une branche inférieure (30), et un circuit de commande muni de circuits de commande individuels (14 à 16, 34 à 36), qui sont montés sur les zones conductrices d'un conducteur en feuille situé sur un substrat du type à circuit imprimé (5) et qui sont agencés en correspondance avec les éléments de commutation à semi-conducteurs (20 à 22, 40 à 42) respectifs, pour amener les éléments de commutation à semi-conducteurs (20 à 22, 40 à 42) à effectuer des opérations de commutation, ledit circuit de commande comportant sur celui-ci le même substrat du type à circuit imprimé que les circuits de commande individuels qui commandent les éléments de commutation à semi-conducteurs (20 à 22) agencés pour les branches supérieures (10), et que les circuits de commande individuels qui commandent les éléments de commutation à semi-conducteurs (40 à 42) agencés pour les branches inférieures (30), caractérisé en ce que les zones conductrices (11 à 13), dans lesquelles sont formés les circuits de commande (14 à 16) individuels qui commandent les éléments de commutation à semi-conducteurs (20 à 22) agencés pour les branches supérieures (10), et la zone conductrice sur laquelle sont formés les circuits de commande (34 à 36) individuels qui commandent les éléments de commutation à semi-conducteurs (40 à 42) agencés pour les branches inférieures (30) sont configurées de telle sorte que celles-ci ne sont pas positionnées en opposition les unes par rapport aux autres en enserrant la couche de matériau isolé du substrat du type à circuit imprimé (5).

2. Dispositif de conversion à semi-conducteur selon la revendication 1, caractérisé en ce que le circuit en pont est un circuit en pont à trois phases.
